# DEMANDE DE BREVET EUROPEEN

(11) **EP 1 950 577 A2**
(43) Date de publication de la demande: **30.07.2008**
(21) Numéro de dépôt: 08000732.1
(22) Date de dépôt: 16.01.2008
(51) Int. Cl.: G01R 31/30, H03K 5/26

(54) **Procede de verification de l'integrite d'un arbre d'horloge**

(30) Priorité: 29.01.2007 FR 0700592
(71) Demandeur: STMICROELECTRONICS SA, 92120 Montrouge (FR)
(72) Inventeur: Bancel, Frederic, 13110 Lamanon (FR); Berard, Nicolas, 13530 Trets (FR)
(74) Mandataire: Marchand, André

(57) **Abrégé**

L'invention concerne un procédé et un dispositif de détection d'erreurs de synchronisation entre des signaux logiques d'un groupe de signaux logique (CK1-CK4). Selon l'invention, un mot de contrôle (CW) est chargé dans un registre à décalage (SREG2) agencé en boucle et cadencé par des signaux logiques résultants (CKO, CKA) égaux au résultat de la fonction OU logique et au résultat de la fonction ET logique appliquée aux signaux logiques du groupe de signaux logiques. La valeur du mot de contrôle est surveillée au fur et à mesure de sa propagation dans le registre à décalage, et un signal d'erreur de synchronisation (SERS) est émis si le mot de contrôle change de valeur. Application notamment à la vérification de l'intégrité d'un arbre d'horloge dans un circuit intégré.

## Description

La présente invention concerne un procédé et un dispositif de vérification de l'intégrité d'un arbre d'horloge, et plus particulièrement un procédé et un dispositif pour détecter des erreurs de synchronisation entre des signaux d'horloge présents dans un même arbre d'horloge.

Les circuits logiques présents dans les circuits intégrés sécurisés, comme les circuits intégrés pour cartes à puce, font l'objet de diverses attaques de la part de fraudeurs qui cherchent à découvrir leur structure et/ou les secrets qu'ils comprennent. Il s'agit par exemple de circuits de cryptographie de type DES, AES, RSA..., de microprocesseurs programmés pour exécuter des algorithmes de cryptographie, de banques de registres contenant des clefs secrètes, etc.

A l'heure actuelle, les méthodes de piratage les plus avancées consistent à injecter des erreurs dans un circuit intégré lors de l'exécution d'opérations dites sensibles, par exemple des opérations d'authentification ou des opérations d'exécution d'un algorithme de cryptographie.

De telles attaques, appelées attaques par injection d'erreur ou injection de faute, peuvent intervenir pendant des phases de calculs dits sensibles, par exemple pendant des phases de calcul d'un code d'identification, ou pendant la lecture d'une clef de cryptographie dans une mémoire. Elles permettent, en combinaison avec des modèles mathématiques et à partir de résultats faux obtenus intentionnellement grâce à des perturbations, de définir un élément secret comme une clef de cryptage ou un mot de passe, de déduire la structure d'un algorithme de cryptographie et/ou les clefs secrètes que l'algorithme utilise, etc.

En particulier, les attaques localisées consistent à introduire des perturbations en un point déterminé du circuit, par exemple au moyen d'un faisceau laser ou un faisceau de rayon X. Une attaque localisée peut concerner la tension d'alimentation, un chemin de données, ou le signal d'horloge du circuit intégré.

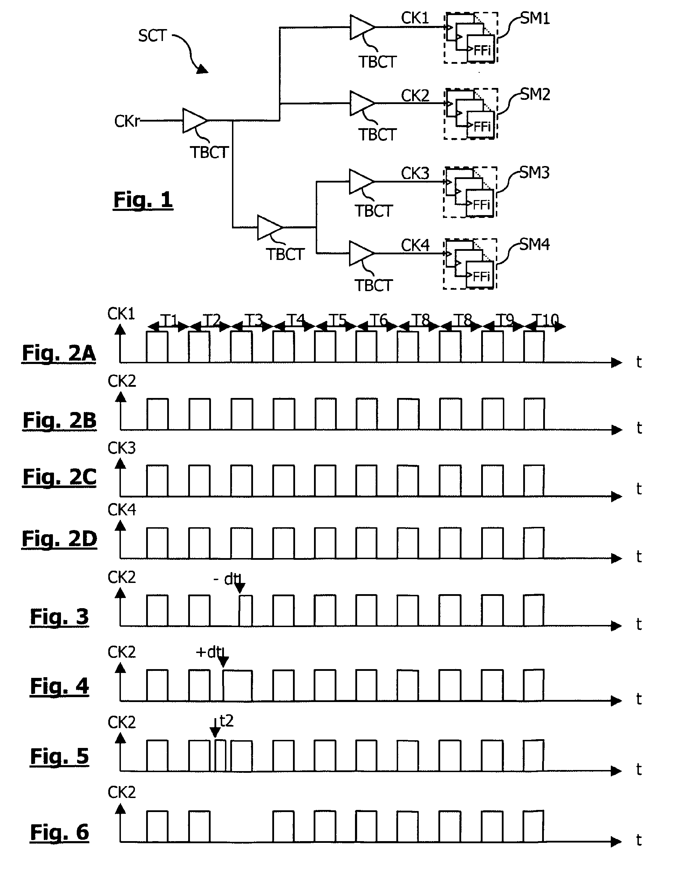

La présente invention concerne notamment les attaques par injection d'erreur localisée dans le signal d'horloge. La figure 1 représente schématiquement un circuit synchrone SCT comprenant quatre modules synchrones SM1, SM2, SM3, SM4 cadencés ("clocked") par un signal d'horloge CKr. Les modules synchrones SM1-SM4 sont schématisés sous forme de blocs comprenant chacun un ensemble de bascules synchrones FFi. Ils reçoivent chacun le signal d'horloge à travers des chemins de conduction de différentes longueurs formant un arbre d'horloge. Plus précisément chaque module synchrone reçoit un signal d'horloge CK1, CK2, CK3, CK4 qui est issu du signal CKr mais qui est susceptible de présenter des différences temporelles propres par rapport au signal CKr, notamment en cas d'injection d'erreur.

Au moment de la conception du circuit synchrone, l'arbre d'horloge est équilibré au moyen de circuits à retard TBCT de manière que les signaux d'horloge CK1 à CK4 soient en phase, comme illustré sur les figures 2A à 2D qui représentent chacune des signaux d'horloge CK1 à CK4. Ainsi, les signaux CK1 à CK4 présentent la même phase, les mêmes cycles T1, T2, T3... et la même période T. Malgré cet équilibrage, les divers signaux d'horloge CK1 à CK4 peuvent présenter, l'un relativement à l'autre, un décalage temporel résiduel "SKW" ("skew") appelé par la suite "erreur tolérée". Cette erreur tolérée n'est pas représentée ici et est très inférieure à la période d'horloge T. Elle n'entraîne pas d'erreur dans le fonctionnement des modules synchrones.

En raison de sa dispersion dans les différentes branches de l'arbre d'horloge, le signal d'horloge CKr est particulièrement vulnérable aux injections d'erreur localisées. Cette vulnérabilité réside dans le fait qu'une attaque peut faire commuter seulement une partie de l'arbre et par conséquent seulement une partie des bascules synchrone du circuit synchrone. Plus particulièrement, les attaques localisées envisageables peuvent se classer en quatre types distincts, et consister à :
- avancer un front d'horloge (accélération),
- retarder un front d'horloge (ralentissement),
- ajouter un créneau d'horloge, ou
- supprimer un créneau d'horloge.

Un exemple d'attaque du premier type est illustré sur la figure 3. L'injection d'erreur est appliquée au signal d'horloge CK2 au cours du cycle T3, et provoque un retard -dt dans l'apparition du front montant du signal d'horloge CK2, lequel devrait normalement intervenir au commencement du cycle T3.

Un exemple d'attaque du second type est illustré sur la figure 4. L'injection d'erreur est appliquée au signal d'horloge CK2 et provoque une avance +dt dans l'apparition du front montant du signal d'horloge CK2, qui apparaît ici avant la fin du cycle T2 au lieu d'apparaitre au commencement du cycle T3.

Un exemple d'attaque du troisième type est illustré sur la figure 5. L'injection d'erreur est appliquée au signal d'horloge CK2 au cours du cycle T2 et provoque l'apparition d'un créneau d'horloge supplémentaire à un instant t2 situé entre le front descendant du créneau d'horloge émis pendant le cycle T2 et le front montant du créneau d'horloge émis au commencement du cycle T3.

Un exemple d'attaque du quatrième type est illustré sur la figure 6. Dans cet exemple l'injection d'erreur est appliquée au signal d'horloge CK2 et provoque la disparition du créneau d'horloge au commencement du cycle T3.

Pour contrer de telles attaques, les procédés habituellement mis en oeuvre consistent à détecter une anomalie dans les données fournies par le circuit synchrone. Ces procédés reposent par exemple sur une redondance logicielle ou matérielle du circuit synchrone. La redondance logicielle consiste dans le fait de recalculer au moyen d'un programme le résultat fournit par le circuit synchrone, le calcul redondant étant effectué par un microprocesseur. Par ailleurs, la redondance matérielle consiste à reproduire en plusieurs exemplaires les parties "sensibles" du circuit synchrone, et de comparer les résultats fournis par les circuits redondants, le résultat majoritaire pouvant être retenu comme résultat fiable en cas de divergence de résultats. De façon générale, ces procédés entrainent une occupation importante de la surface de semiconducteur disponible (redondance matérielle) ou un ralentissement notable du fonctionnement des circuits synchrones (redondance logicielle).

Au lieu de détecter une erreur de résultat consécutive à une injection d'erreur, qui constitue l'effet second de l'injection d'erreur, l'invention propose de détecter l'effet premier de l'injection d'erreur, c'est-à-dire l'apparition d'une désynchronisation entre les signaux d'horloge présents dans les branches de l'arbre d'horloge.

L'invention propose ainsi de vérifier l'intégrité de chacune des branches d'un arbre d'horloge vis à vis des autres branches de l'arbre.

Plus particulièrement, l'invention propose de vérifier que les branches de l'arbre d'horloge sont commutées à chaque cycle d'horloge, qu'elles ne sont commutées qu'une fois et une seule à chaque cycle d'horloge, et ceci sans qu'apparaisse un décalage temporel supérieur à la valeur maximale de l'erreur tolérée SKW. L'invention permet ainsi de garantir qu'il n'y a pas eu de perte ni d'ajout d'un cycle d'horloge, ni de retard ou d'avance sur chacune des branches de l'arbre d'horloge.

Un mode de réalisation de l'invention concerne un procédé de détection d'erreurs de synchronisation entre des signaux logiques d'un groupe de signaux logiques, comprenant les étapes consistant à : prévoir un registre à décalage comprenant une première cellule synchrone et une seconde cellule synchrone ; charger un mot de contrôle dans le registre à décalage ; cadencer la première cellule synchrone au moyen d'un premier signal logique résultant égal au résultat de la fonction OU logique appliquée aux signaux logiques du groupe de signaux logiques ; cadencer la seconde cellule synchrone au moyen d'un second signal logique résultant égal au résultat de la fonction ET logique appliquée aux signaux logiques du groupe de signaux logiques ; propager le mot de contrôle en boucle dans le registre à décalage au rythme des signaux logiques résultants et surveiller la valeur du mot de contrôle au fur et à mesure de sa propagation, et détecter une erreur de synchronisation si le mot de contrôle change de valeur.

Selon un mode de réalisation, le procédé comprend les étapes consistant à produire un signal d'erreur asynchrone ayant une valeur inactive et une valeur active, et porter le signal d'erreur asynchrone à la valeur active quand le mot de contrôle change de valeur, échantillonner le signal d'erreur asynchrone après chaque décalage du mot de contrôle dans le registre à décalage, afin de filtrer des erreurs de synchronisation tolérées et de produire un signal d'erreur synchrone.

Selon un mode de réalisation, le signal d'erreur synchrone est rafraichi cycliquement par des fronts du premier signal logique résultant.

Selon un mode de réalisation, le procédé comprend les étapes consistant à charger dans le registre à décalage un mot de contrôle comprenant au moins un couple de bits de contrôle ayant des valeurs logiques inverses, et détecter une erreur de synchronisation si les bits de contrôle présentent la même valeur au cours de la propagation du mot de contrôle dans le registre à décalage.

Selon un mode de réalisation, le procédé comprend une étape consistant à introduire entre la première cellule synchrone et la seconde cellule synchrone un retard de propagation au moins égal à un décalage temporel maximal toléré entre les signaux logiques.

Selon un mode de réalisation, l'étape de chargement du mot de contrôle comprend une étape consistant à initialiser chaque cellule synchrone du registre à décalage avec un signal de mise à 0 ou de mise à 1 de la cellule.

Selon un mode de réalisation, les cellules synchrones du registre à décalage sont des bascules comprenant chacune une entrée d'horloge recevant l'un des signaux logiques résultants, une entrée de données et une sortie de données inverseuse ou non inverseuse.

Selon un mode de réalisation, les signaux logiques dont la synchronisation doit être surveillée sont des signaux d'horloge prélevés en divers points d'un arbre d'horloge et issus d'un même signal d'horloge.

Un mode de réalisation de l'invention concerne également un dispositif de détection d'erreurs de synchronisation entre des signaux logiques d'un groupe de signaux logiques, comprenant un registre à décalage comprenant une première cellule synchrone et une seconde cellule synchrone, des moyens pour charger un mot de contrôle dans le registre à décalage, des moyens pour connecter la sortie du registre à décalage à l'entrée du registre à décalage, des moyens pour cadencer la première cellule synchrone au moyen d'un signal logique résultant égal au résultat de la fonction OU logique appliquée aux signaux logiques du groupe de signaux logiques, des moyens pour cadencer la seconde cellule synchrone au moyen d'un signal logique résultant égal au résultat de la fonction ET logique appliquée aux signaux logiques du groupe de signaux logiques, et des moyens pour surveiller la valeur du mot de contrôle au fur et à mesure de sa propagation en boucle dans le registre à décalage au rythme des signaux logiques, et émettre un signal d'erreur de synchronisation si le mot de contrôle change de valeur.

Selon un mode de réalisation, les moyens pour surveiller la valeur du mot de contrôle comprennent des moyens pour produire un signal d'erreur asynchrone ayant une valeur inactive et une valeur active, et porter le signal d'erreur asynchrone à la valeur active quand le mot de contrôle change de valeur, et des moyens pour échantillonner le signal d'erreur asynchrone après chaque décalage du mot de contrôle dans le registre à décalage, afin de filtrer des erreurs de synchronisation tolérées et produire un signal d'erreur synchrone.

Selon un mode de réalisation, les moyens pour échantillonner le signal d'erreur asynchrone sont pilotés par des fronts du premier signal logique résultant.

Selon un mode de réalisation, les moyens pour charger un mot de contrôle sont agencés pour charger dans le registre à décalage un mot de contrôle comprenant un couple de bits de contrôle ayant des valeurs logiques inverses, et les moyens pour surveiller la valeur du mot de contrôle sont agencés pour émettre le signal d'erreur si les bits de contrôle présentent la même valeur au cours de la propagation du mot de contrôle dans le registre à décalage.

Selon un mode de réalisation, le registre à décalage comprend, entre la première cellule synchrone et la seconde cellule synchrone, un circuit à retard introduisant un retard de propagation au moins égal à un décalage temporel maximal toléré entre les signaux logiques.

Selon un mode de réalisation, les moyens pour charger un mot de contrôle dans le registre à décalage comprennent un signal de mise à 0 ou de mise à 1 de chaque cellule synchrone du registre à décalage.

Selon un mode de réalisation, les cellules synchrones du registre à décalage sont des bascules comprenant chacune une entrée d'horloge recevant l'un des signaux logiques résultants, une entrée de données et une sortie de données inverseuse ou non inverseuse.

Selon un mode de réalisation, le dispositif comprend des entrées connectées en divers points d'un arbre d'horloge recevant les signaux logiques dont la synchronisation doit être surveillée, les signaux logiques dont la synchronisation doit être surveillée étant des signaux d'horloge issus d'un même signal d'horloge.

Un mode de réalisation de l'invention concerne également un circuit synchrone comprenant des modules synchrones cadencés par des signaux logiques véhiculés par un arbre d'horloge, et un dispositif de détection d'erreurs de synchronisation selon l'invention

Un mode de réalisation de l'invention concerne également un circuit intégré comprenant des organes synchrones cadencés par des signaux logiques véhiculés par un bus d'horloge, et un dispositif de détection d'erreurs de synchronisation selon l'invention.

Ces caractéristiques seront exposées plus en détail dans la description suivante d'un exemple de réalisation du dispositif de détection d'erreurs de synchronisation selon l'invention, faite à titre non limitatif en relation avec les figures jointes parmi lesquelles :
- la figure 1 précédemment décrite représente schématiquement un circuit synchrone comprenant un arbre d'horloge,
- les figures 2A à 2D précédemment décrites sont des chronogrammes représentant des signaux d'horloge présents dans des branches de l'arbre d'horloge,
- les figures 3 à 6 précédemment décrite sont des chronogrammes illustrant respectivement une injection dans l'arbre d'horloge d'une erreur d'un premier type, d'un second type, d'un troisième type et d'un quatrième type,
- la figure 7 représente schématiquement un circuit synchrone comprenant un arbre d'horloge et un dispositif de détection d'erreurs de synchronisation entre des branches de l'arbre d'horloge,
- la figure 8 représente un premier exemple de réalisation du dispositif représenté en figure 7,
- la figure 9 représente un exemple de réalisation d'un registre à décalage présent dans le dispositif de la figure 8,
- la figure 10 représente un exemple de réalisation selon l'invention du dispositif de détection représenté en figure 7,
- les figures 11A à 11I sont des chronogrammes illustrant le fonctionnement normal du dispositif de la figure 10 en l'absence d'erreur de synchronisation,
- les figures 12A à 12I, 13A à 13I, 14A à 14I, 15A à 15I, 16A à 16I sont des chronogrammes illustrant le fonctionnement du dispositif de la figure 10 en réponse à une injection dans l'arbre d'horloge d'une erreur d'un premier type, d'un second type, d'un troisième type, d'un quatrième type et d'un cinquième type, respectivement,
- la figure 17 représente l'architecture d'un circuit intégré comprenant un dispositif de détection selon l'invention.

Dans l'ensemble de la présente demande, il est considéré que les fronts de variation du signal d'horloge provoquant le déclenchement des éléments synchrones d'un circuit synchrone, ou front actifs, sont des fronts montants. Toutefois, une convention inverse peut être retenue. Dans ce cas, ce qui est indiqué dans la présente demande au sujet des fronts montants concerne les fronts descendants.

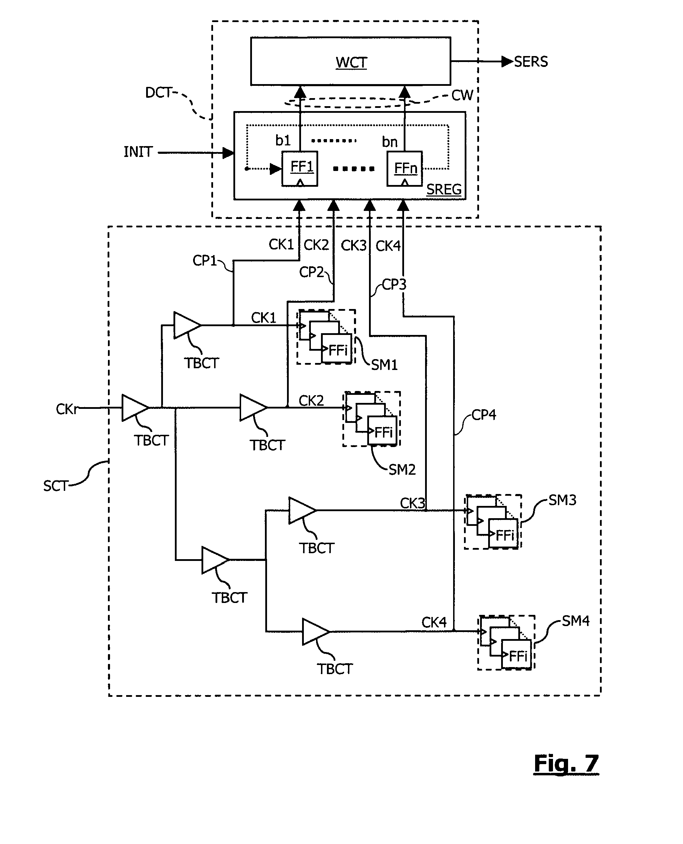

La figure 7 représente un circuit synchrone SCT identique à celui de la figure 1, comprenant quatre modules synchrones SM1, SM2, SM3, SM4 et un arbre d'horloge fournissant respectivement aux modules synchrones SM1 à SM4 des signaux d'horloge CK1, CK2, CK3, CK4 issus d'un même signal d'horloge CKr. Le circuit SCT est équipé d'un dispositif DCT pour détecter des erreurs de synchronisation entre les signaux CK1 à CK4, soit un défaut d'intégrité de l'arbre d'horloge.

Le dispositif DCT reçoit les signaux CK1 à CK4, prélevés ici sur les entrées d'horloge des modules SM1 à SM4 au moyen de chemins de conduction CP1, CP2, CP3, CP4. Si nécessaire, et bien que cela ne soit pas représenté, les chemins de conduction CP1 à CP4 sont eux-mêmes équilibrés au moyen de circuits à retard TBCT du même type que ceux utilisés pour équilibrer l'arbre d'horloge.

Le dispositif de détection DCT comprend un registre à décalage SREG et un circuit de surveillance WCT. Le registre à décalage SREG comprend n cellules synchrones FF1 à FFn cadencées par les signaux d'horloge CK1, CK2, CK3, CK4. Les cellules FF1 à FFn reçoivent un signal d'initialisation INIT permettant de charger dans le registre à décalage SREG un mot de contrôle CW de n bits b1 à bn. Le mot de contrôle CW est surveillé par le circuit WCT qui fournit un signal d'erreur SERS ayant une valeur inactive et une valeur active.

Les cellules FF1 à FFn étant cadencées par les signaux d'horloge CK1 à CK4, le mot de contrôle CW se propage dans le registre à décalage au rythme de ces divers signaux d'horloge. Une erreur de synchronisation entre les signaux d'horloge CK1 à CK4 entraîne un changement de la valeur du mot de contrôle CW et un tel changement de valeur est détecté par le circuit de surveillance WCT qui met alors le signal d'erreur SERS à sa valeur active, par exemple 0.

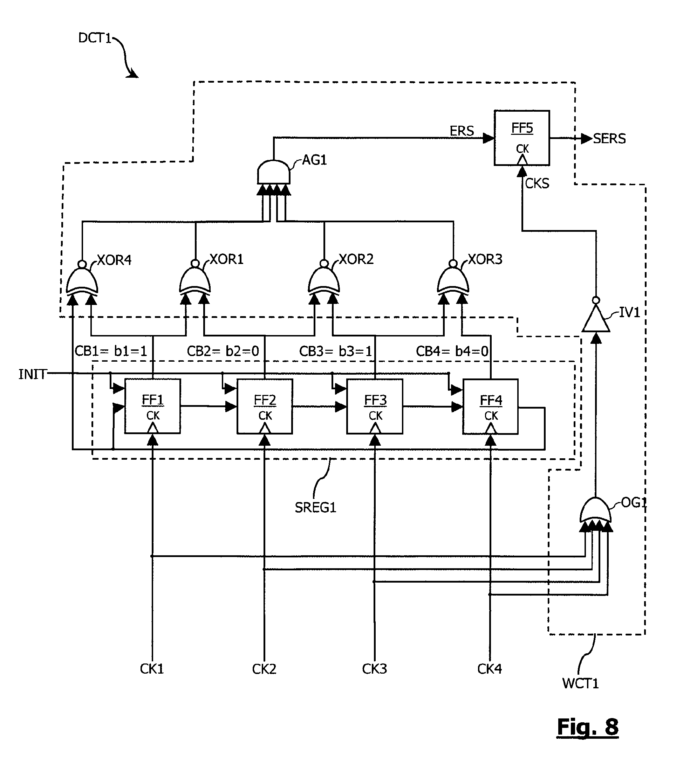

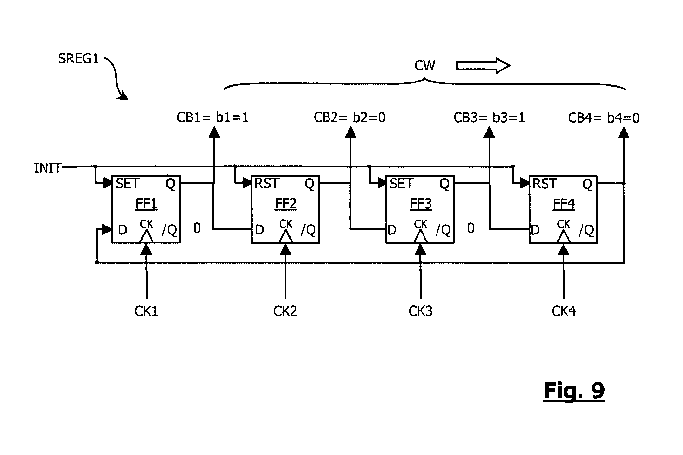

La figure 8 représente un exemple de réalisation DCT1 du dispositif de détection, comprenant un registre à décalage SREG1 et un circuit de surveillance WCT1. La figure 9 illustre un exemple de réalisation du registre SREG1.

Sur la figure 8, le registre SREG1 comprend quatre bascules FF1 à FF4 comprenant chacune une entrée de donnée D, un sortie de données Q, une sortie de données inverseuse /Q, une entrée d'horloge CK, une entrée SET de mise à 1 et une entrée RST de mise à 0. L'entrée d'horloge de la bascule FF1 reçoit le signal d'horloge CK1, l'entrée d'horloge de la bascule FF2 reçoit le signal d'horloge CK2, l'entrée d'horloge de la bascule FF3 reçoit le signal d'horloge CK3 et l'entrée d'horloge de la bascule FF4 reçoit le signal d'horloge CK4.

Sur la figure 9, la sortie Q de la bascule FF1 fournit un bit de contrôle CB1 et est connectée à l'entrée D de la bascule FF2. La sortie Q de la bascule FF2 fournit un bit de contrôle CB2 et est connectée à l'entrée D de la bascule FF3. La sortie Q de la bascule FF3 fournit un bit de contrôle CB3 et est connectée à l'entrée D de la bascule FF4. La sortie Q de la bascule FF4 fournit un bit de contrôle CB4 et est connectée à l'entrée D de la bascule FF1. Le signal INIT est appliqué sur les entrées SET des bascules FF1 et FF3 et sur les entrée RST des bascules FF2 et FF4.

Le circuit de surveillance WCT1 comprend quatre portes XOR1, XOR2, XOR3, XOR4 de type OU EXCLUSIF à deux entrées chacune, une porte AG1 de type ET à quatre entrées, une porte OG1 de type OU à quatre entrées, une porte inverseuse IV1 et une bascule FF5. Les entrées de la porte XOR1 reçoivent les bits de contrôle CB1, CB2, les entrées de la porte XOR2 reçoivent les bits de contrôle CB2, CB3, les entrées de la porte XOR3 reçoivent les bits de contrôle CB3, CB4 et les entrées de la porte XOR4 reçoivent les bits de contrôle CB4, CB1. Les entrées de la porte AG1 reçoivent les sorties des portes XOR1 à XOR4 et la sortie de la porte AG1 fournit un signal d'erreur asynchrone ERS. Ce dernier est appliqué à l'entrée de la bascule FF5, dont la sortie fournit le signal d'erreur synchrone SERS. Les entrées de la porte OG1 reçoivent les quatre signaux d'horloge CK1 à CK4. La sortie de la porte OG1 est appliquée à la porte inverseuse IV1 qui fournit un signal d'échantillonnage CKS. Le signal CKS est appliqué à l'entrée d'horloge de la bascule FF5, laquelle recopie ainsi le signal ERS à chaque front montant du signal CKS.

Le registre à décalage SREG1 présente ainsi des cycles de décalage T1, T2, T3, T4, T5,... de période égale à la période des signaux CK1 à CK4. Lorsque le signal INIT est appliqué aux bascules, par exemple un front montant de ce signal, un mot de contrôle CW comprenant des bits b1, b2, b3, b4 respectivement égaux à 1, 0, 1 et 0 est chargé dans le registre à décalage. Les bits b1 à b4 du mot de contrôle CW se propagent ensuite en boucle dans le registre, de sorte que la valeur des bits de contrôle CB1 à CB4 fournie par le registre est égale à 1010, puis 0101, puis de nouveau 1010, puis de nouveau 0101, etc.

Lorsque le registre contient l'une des valeurs "0101" ou "1010", chacune des portes XOR1 à XOR4 reçoit une combinaison de bits de contrôle "01" ou "10" et les sorties respectives des portes XOR sont égales à 1, de sorte que le signal d'erreur ERS est égal à 1 (valeur inactive). Si l'une des combinaisons des bits de contrôle devient égale à "00" ou "11", au moins une des portes XOR passe à 0 et le signal ERS passe à 0. Si l'erreur est persistante lorsque le signal CKS présente un front montant, le signal SERS passe également à 0 indiquant ainsi qu'une erreur de synchronisation entre les signaux d'horloge CK1 à CK4 est intervenue. Une telle erreur est considérée comme représentative d'une attaque localisée de l'arbre d'horloge.

Ce mode de réalisation du dispositif de détection nécessite un registre à décalage contenant un nombre de cellules synchrones pair et au moins égal au nombre de signaux d'horloge à surveiller, ce qui peut devenir problématique lorsque le nombre de signaux d'horloge à surveiller est très important (ce nombre étant limité à quatre dans les exemples décrits dans la présente demande, dans un souci de simplicité).

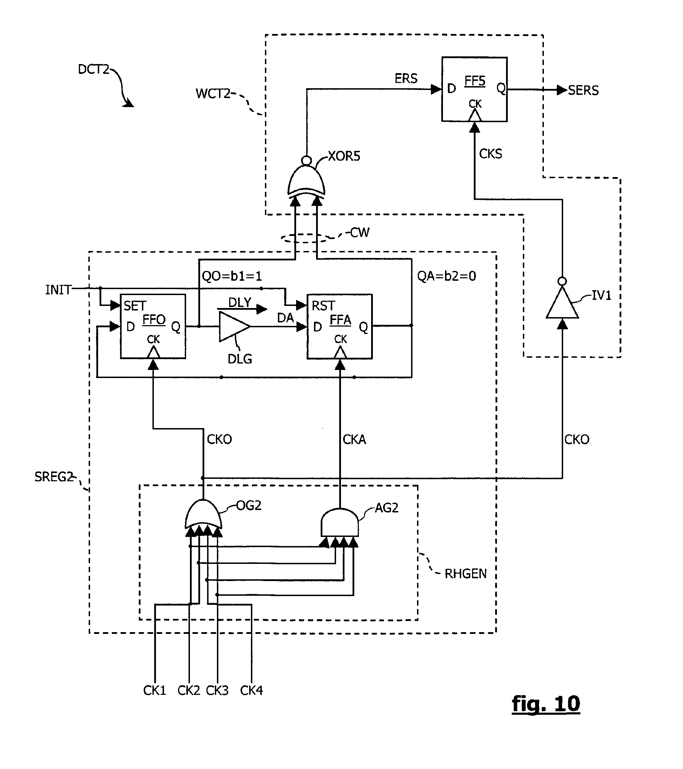

La figure 10 représente un mode de réalisation DCT2 selon l'invention du dispositif de détection, qui ne nécessite que deux cellules synchrones, ici deux bascules FFO, FFA de même structure que les bascules FF1 à FF4 précédemment décrites. Le dispositif de détection DCT2 comprend un registre à décalage SREG2 et un circuit de surveillance WCT2. Le registre à décalage SREG2 comprend les bascules FFO, FFA et un circuit auxiliaire RHGEN. Le circuit RHGEN comprend une porte OG2 de type OU à quatre entrées et une porte AG2 de type ET à quatre entrées. Chacune de ces portes reçoit les signaux d'horloge CK1 à CK4. Ainsi, la porte OG2 fournit un signal d'horloge CKO qui est le résultat du OU logique de tous les signaux d'horloge CK1 à CK4 tandis que la porte AG2 fournit un signal d'horloge CKA qui est le résultat du ET logique de tous les signaux d'horloge CK1 à CK4.

Le signal d'horloge CKO est appliqué à l'entrée d'horloge CK de la bascule FFO et le signal d'horloge CKA est appliqué à l'entrée d'horloge CK de la bascule FFA. Le signal INIT est appliqué à l'entrée SET de la bascule FFO et à l'entrée RST de la bascule FFA. La sortie Q de la bascule FFA fournit un bit de contrôle QA qui est appliqué à l'entrée D de la bascule FFO. La sortie Q de la bascule FFO fournit un bit de contrôle QO qui est appliqué à l'entrée D de la bascule FFA par l'intermédiaire d'un circuit à retard DLG introduisant un retard DLY entre l'instant où un front montant ou descendant apparaît sur la sortie Q de la bascule FFA et l'instant où ce front est appliqué à l'entrée D de la bascule FFA. Le bit appliqué à l'entrée D de la bascule FFA sera désigné DA pour le distinguer du bit de contrôle QO.

Pour des raisons qui apparaîtront plus loin, le retard DLY est de préférence au moins égal à la valeur maximale de l'erreur tolérée SKW (erreur d'équilibrage de l'arbre d'horloge). De préférence, le retard DLY ne doit toutefois pas être très supérieur à cette valeur maximale. Dans le cas contraire, le dispositif pourrait ne pas détecter des erreurs de synchronisation de courte durée intervenant dans un intervalle de temps compris entre la fin du délai d'erreur SKW, calculé après un changement de cycle d'horloge, et la fin du retard DLY, également calculé après un changement de cycle d'horloge. Ainsi, de préférence, le retard DLY doit être sensiblement supérieur mais très proche de la valeur maximale de l'erreur tolérée SKW.

Le circuit de surveillance WCT2 comprend ici une porte XOR5 de type OU EXCLUSIF à deux entrées ainsi que la porte inverseuse IV1 et la bascule FF5 précédemment décrites. La porte XOR5 reçoit les bits de contrôle QO, QA et fournit le signal d'erreur asynchrone ERS qui est comme précédemment appliqué à l'entrée D de la bascule FF5 dont la sortie fournit le signal d'erreur synchrone SERS. La porte inverseuse IV1 reçoit ici le signal d'horloge résultant CKO, équivalent au signal fournit par la porte OG1 sur la figure 8, et applique le signal d'échantillonnage CKS à l'entrée d'horloge CK de la bascule FF5.

Après application du signal INIT aux bascules FFO, FFA, un mot de contrôle CW ne comprenant que deux bits b1 et b2, respectivement égaux à 1 et 0, est chargé dans le registre à décalage (un mot de contrôle égal à 01 pouvant également être prévu). Les signaux CKO et CKA présentent des cycles d'horloge correspondant aux cycles d'horloge des signaux d'horloge CK1 à CK4, et cadencent le registre SREG2 de manière que le mot de contrôle CW se propage en boucle dans celui-ci, de sorte que la porte XOR5 reçoit des couples de bits QO, QA égaux à 01 ou 10 et les signaux d'erreur ERS ou SERS restent égaux à 1.

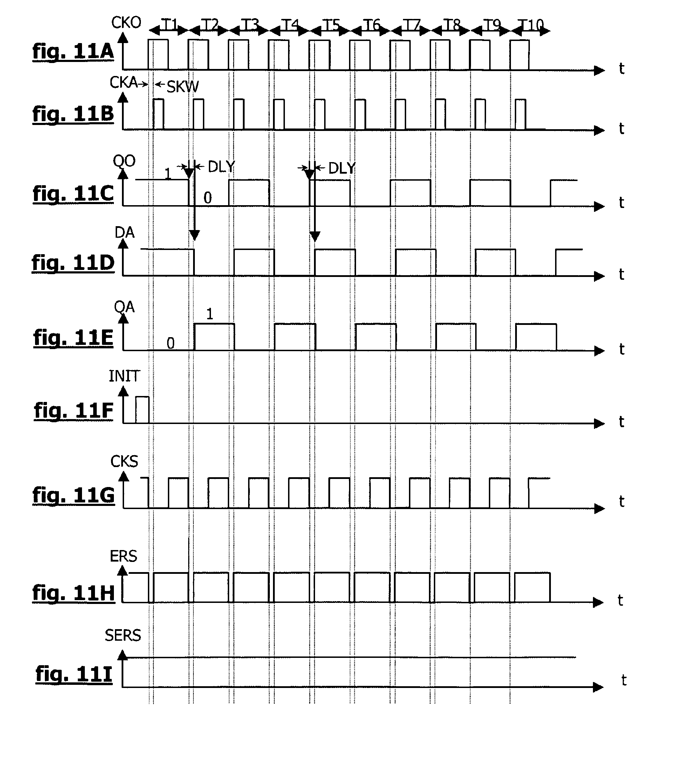

L'utilisation des signaux d'horloge résultant CKO et CKA permet de simplifier considérablement la structure du dispositif de détection sans perte de sensibilité en termes de détection des erreurs de synchronisation. Toute erreur injectée dans l'un des signaux CK1 à CK4 se traduit immanquablement par une erreur équivalente sur l'un des signaux d'horloge résultant CKO ou CKA et entraîne le basculement du signal d'erreur SERS dans l'état actif, comme cela sera mieux compris en se référant aux chronogrammes représentés sur les figures 11A à 16I.

Le fonctionnement du dispositif DCT2 pendant des cycles T1 à T10 est illustré par les figures 11A à 11I, 12A à 12I, 13A à 13I, 14A à 14I et 15A à 15I, 16A à 16I, dans lesquelles :
- les figures 11A à 16A représentent le signal CKO,
- les figures 11B à 16B représentent le signal CKA,
- les figures 11C à 16C représentent le bit de contrôle QO,
- les figures 11D à 16D représentent le bit DA à l'entrée D de la bascule FFA (sortie du circuit à retard DLG),
- les figures 11E à 21E représentent le bit de contrôle QA,
- les figures 11F à 16F représentent le signal INIT,
- les figures 11G à 16G représentent le signal CKS,
- les figures 11H à 16H représentent le signal ERS, et
- les figures 11I à 16I représentent le signal SERS.

Dans ces chronogrammes, l'erreur tolérée SKW a été sensiblement dilatée pour des raisons de lisibilité des figures.

Les figures 11A à 11I illustrent le fonctionnement du dispositif DCT2 en l'absence d'erreur de synchronisation. Il apparaît que le signal d'horloge CKA présente des fronts montants en retard sur les fronts montants du signal CKO et des fronts descendants en avance sur les fronts descendants du signal CKO. Le signal CKO étant le résultat de la fonction OU de tous les signaux d'horloge à surveiller CK1 à CK4, il suffit en effet que l'un des signaux d'horloge passe à 1 pour que le signal CKO passe à 1. Inversement, le signal CKA étant le résultat de la fonction ET de tous les signaux d'horloge CK1 à CK4, le signal CKA ne passe à 1 que lorsque tous les signaux CK1 à CK4 sont égaux à 1 et passe à 0 lorsqu'au moins un des signaux d'horloge passe à 0. L'erreur tolérée SKW entre les signaux CK1 à CK4 est ainsi la cause du retard dans l'apparition des fronts montants du signal CKA par rapport aux fronts montants du signal CKO, ces derniers apparaissant ici immédiatement au commencement de chaque cycle d'horloge T1 à T10.

Également, il apparaît que le bit DA recopie le bit QO avec le retard DLY qui est au moins égal à la valeur maximale de l'erreur tolérée SKW, de sorte qu'au moment où apparaît un front montant du signal CKA, le bit QA recopie la valeur du bit DA qui est encore égale à la valeur que présentait le bit QO au moment où est apparu le front montant du signal CKO. Ainsi, le retard DLY permet de corriger la désynchronisation due au fait que les signaux d'horloge CKO et CKA présentent des fronts montants sensiblement décalés en raison de l'erreur tolérée SKW.

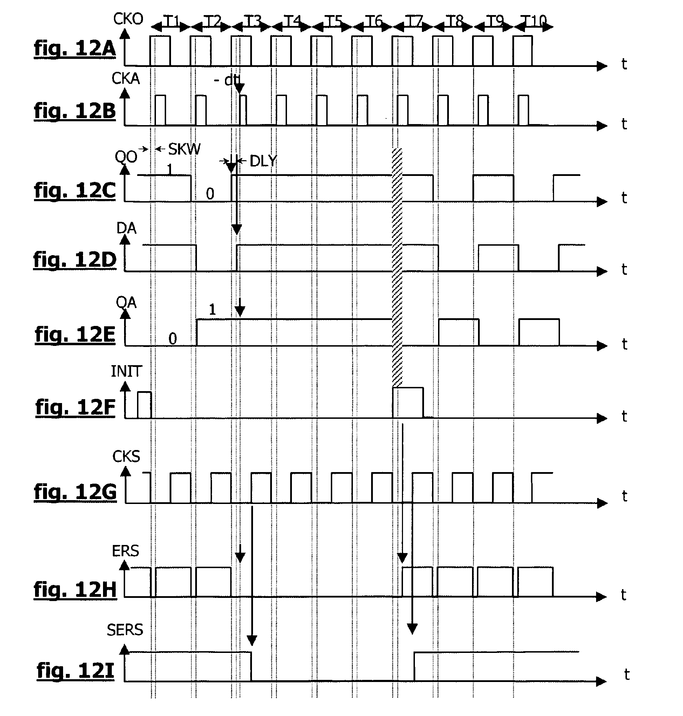

Les figures 12A à 12I illustrent le fonctionnement du dispositif DCT2 dans le cas d'une injection d'erreur appliquée à l'un quelconque des signaux d'horloge CK1 à CK4 au cours du cycle T3, ou à plusieurs de ces signaux, provoquant un retard -dt dans l'apparition du front montant du ou des signaux d'horloge concernés, par rapport au commencement du cycle T3. Ce retard se répercute sur le signal d'horloge CKA (effets de la fonction ET) et provoque un retard similaire -dt dans l'apparition du front montant du signal d'horloge CKA par rapport au commencement du cycle T3. Ce retard -dt est supposé plus important que l'erreur tolérée SKW et provoque un retard égal à "dt-SKW" dans l'apparition du front montant du signal CKA (fig. 12B). Ainsi, lorsque le bit DA recopie le bit QO (avec le retard DLY) et passe à 1, la bascule FFA n'a pas encore commuté. Lorsque la bascule FFA commute, le bit DA est devenu égal à 1 et le bit de contrôle QA, qui recopie le bit DA, reste égal à 1 au lieu de passer à 0. Le signal d'erreur asynchrone ERS, au lieu de repasser à 1, reste égal à 0. Au milieu du cycle d'horloge, le signal SERS passe lui-même à 1 (passage à 0 de CKO) et reste égal à 0 tant que le signal INIT n'a pas été appliqué au dispositif de détection, ici au cours du cycle T7. En effet, après l'erreur sur le bit QA, les deux bits de contrôle sont égaux à 1 et l'erreur se maintient de cycle en cycle dans le registre à décalage.

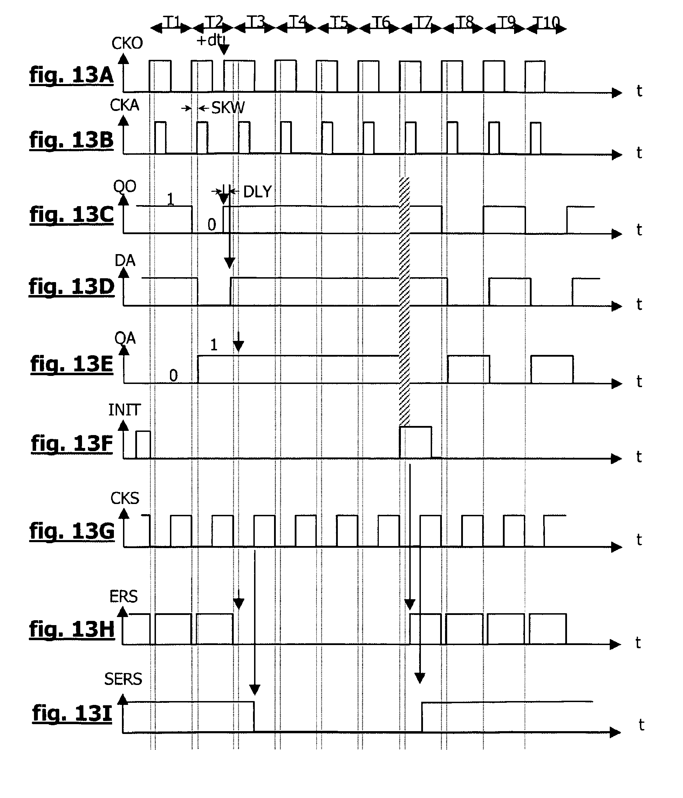

Les figures 13A à 13I illustrent le fonctionnement du dispositif DCT2 dans le cas d'une injection d'erreur appliquée à l'un des signaux d'horloge CK1 à CK4 ou à plusieurs de ces signaux d'horloge, provoquant une avance +dt dans l'apparition du front montant du signal d'horloge concerné ou des fronts montants des signaux d'horloge concernés. Cette avance se répercute sur le signal d'horloge CKO (effets de la fonction OU) et provoque une avance similaire +dt dans l'apparition du front montant du signal CKO, qui apparaît ici avant la fin du cycle T2 au lieu d'apparaitre au commencement du cycle T3. Ainsi, le bit de contrôle QO recopie le bit de contrôle QA et passe à 0 prématurément. Lorsque le front montant du signal CKA apparaît, le bit DA est déjà passé à 1 et le bit QA passe également à 1. Comme précédemment les deux bits de contrôle sont donc égaux à 1, le signal ERS puis le signal SERS passent à 0 et restent égaux à 0 jusqu'au cycle T7 où le signal INIT est appliqué au dispositif de détection.

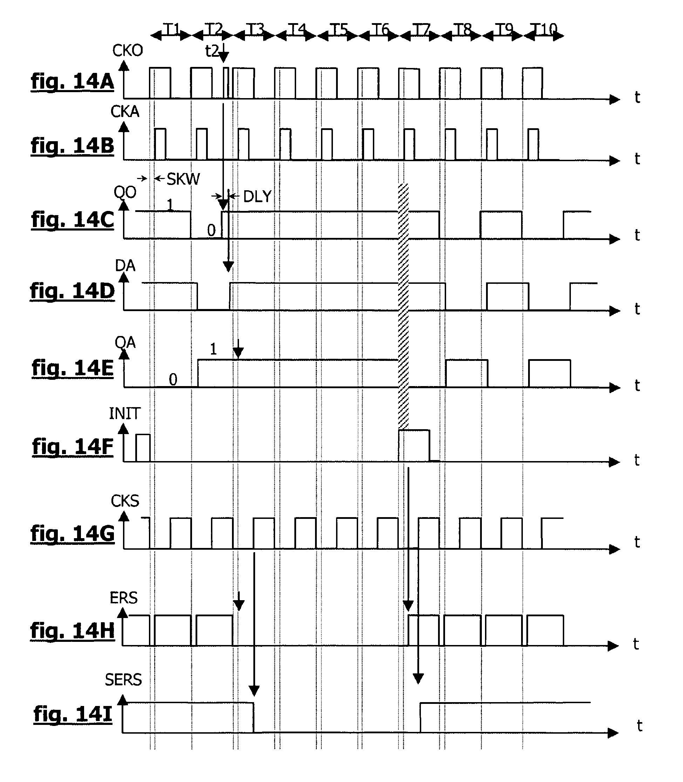

Les figures 14A à 14I illustrent le fonctionnement du dispositif DCT2 dans le cas d'une injection d'erreur appliquée à l'un des signaux d'horloge CK1 à CK4 ou à plusieurs de ces signaux, provoquant l'apparition d'un créneau d'horloge supplémentaire à un instant t2 situé entre le front descendant du créneau d'horloge émis pendant le cycle T2 et le front montant du créneau d'horloge émis pendant le cycle T3. L'erreur se répercute sur le signal résultant CKO qui présente également le créneau d'horloge supplémentaire. Ce créneau parasite provoque comme précédemment le passage à 1 anticipé du bit QO puis du bit DA, et le bit QA reste ensuite égal à 1 au lieu de passer à 0, de sorte que les signaux d'erreur ERS et SERS passent successivement à 0.

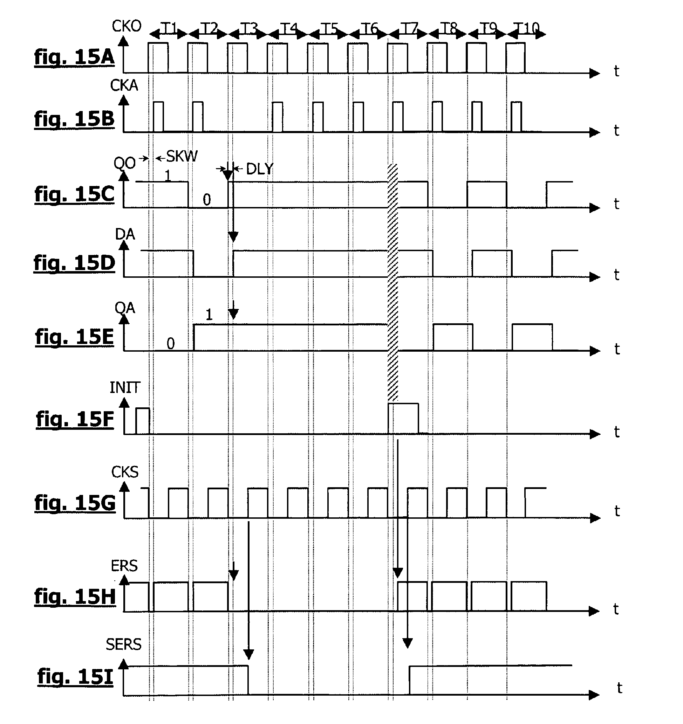

Les figures 15A à 15I illustrent le fonctionnement du dispositif DCT2 dans le cas d'une injection d'erreur dans un ou plusieurs signaux d'horloge CK1 à CK4, provoquant la disparition du créneau d'horloge du ou des signaux d'horloge concernés. L'erreur se répercute sur le signal d'horloge CKA qui présente également une absence de créneau d'horloge au cours du cycle T3. De ce fait, la bascule FFA ne commute pas et le bit QA reste égal à 1 au lieu de passer à 0. Comme précédemment les deux bits de contrôle sont donc égaux à 1, le signal ERS puis le signal SERS passent à 0 et restent égaux à 0 jusqu'au cycle T7 où le signal INIT est appliqué au dispositif de détection.

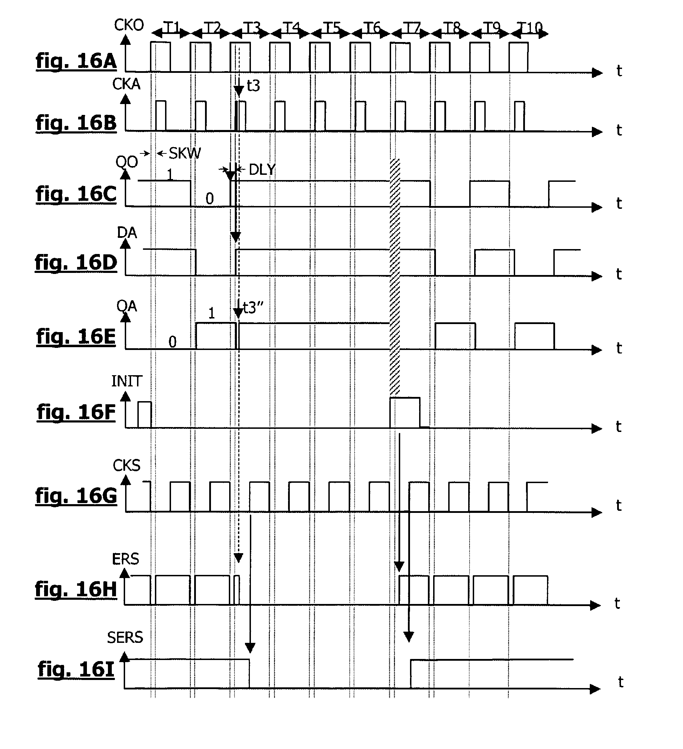

Les figures 16A à 16I illustrent le fonctionnement du dispositif DCT2 dans le cas d'une injection d'erreur d'un cinquième type qui est en réalité équivalente à l'injection d'erreur du troisième type (ajout d'un créneau d'horloge). L'erreur est appliquée à un ou à plusieurs signaux d'horloge CK1 à CK4 au cours du cycle T3 et se traduit par l'apparition d'une perturbation formant un "trou" dans le créneau d'horloge du signal d'horloge concerné ou des signaux d'horloge concernés. Ce trou se répercute sur le signal d'horloge CKA et provoque un trou similaire dans le créneau CKA du cycle T3. La réapparition du signal CKA à un instant t3, au terme de la perturbation, forme un second front montant au cours du cycle T3 et correspond à l'ajout d'un créneau d'horloge CKA parasite. Ce créneau parasite provoque un basculement à 1 du bit de contrôle QA peu de temps après son passage à 0, de sorte que les deux bits de contrôle sont à nouveau égaux à 1. Le signal ERS passe à 0 puis le signal SERS passe également à 0 et reste égal à 0 jusqu'au moment où le signal INIT est de nouveau appliqué au dispositif de détection.

Il apparaîtra clairement à l'homme de l'art que la présente invention est susceptible de diverses variantes de réalisation. L'utilisation de bascules synchrones du type décrit plus haut n'est pas indispensable pour la mise en oeuvre de l'invention. Le registre à décalage pourrait être réalisé par exemple à partir d'une mémoire volatile (mémoire RAM) contrôlée par un circuit logique cadencé par les divers signaux d'horloge à surveiller, en faisant transiter les bits du mot de contrôle d'une cellule mémoire à l'autre, chaque cellule mémoire formant alors une cellule de registre à décalage.

La présente invention est également susceptible de diverses applications. Sur la figure 7, la représentation schématique conventionnelle des modules synchrones SM1-SM4 désigne tout type de circuit synchrone comme un microprocesseur ou un organe de microprocesseur, un circuit de calcul cryptographique ou une partie d'un tel circuit, un circuit de décodage d'adresse, un circuit de lecture d'une mémoire ou une partie d'un tel circuit, etc.

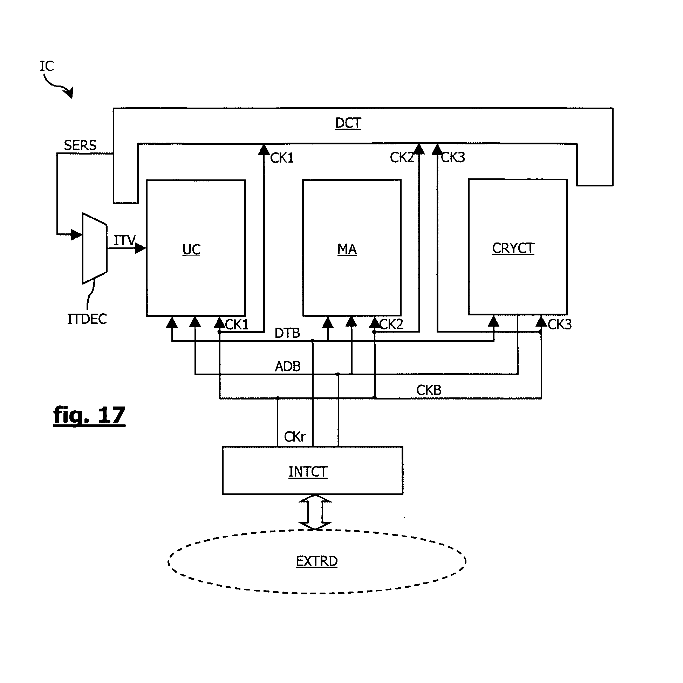

La figure 17 illustre un exemple d'application de l'invention à un circuit intégré IC pour carte à puce ou étiquette électronique. Le circuit intégré IC comprend une unité centrale UC de microprocesseur, un plan mémoire MA contenant des zones mémoire volatile (RAM) et des zones mémoire non volatile (ROM, EEPROM, FLASH...), un circuit de cryptographie CRYCT permettant au circuit intégré de s'authentifier au cours d'une transaction, et un circuit d'interface INTCT lui permettant de communiquer avec des lecteurs de carte à puce ou d'étiquette électronique externes (EXTRD). Le circuit d'interface INTCT peut être du type à contact et comprendre par exemple des contacts ISO 7816 (contacts d'horloge, de données, d'alimentation, de masse...). Il peut aussi être du type sans contact RFID (Radio Frequency Identification) et comprendre une bobine d'antenne RF ou un circuit d'antenne UHF, des circuits de modulation et démodulation de données sortantes et entrantes, un circuit extracteur d'horloge, etc. L'unité centrale UC, le plan mémoire MA et le circuit CRYCT sont reliés par un bus de données DTB, un bus d'adresse ADB et un bus d'horloge CKB. Dans une telle application, la source d'un signal d'horloge est généralement située dans le circuit d'interface (contact ISO 7816 fournissant le signal d'horloge ou circuit extrayant le signal d'horloge d'une porteuse RF ou UHF) mais peut aussi être implantée dans le circuit intégré si celui-ci possède une alimentation autonome en énergie électrique (pile électrique). L'arbre d'horloge est formé ici par les ramifications du bus d'horloge ainsi que des ramifications internes à chaque élément UC, MA, CRYCT qui ne sont pas représentées.

Le circuit intégré est équipé d'un circuit DCT selon l'invention, assurant la détection des erreurs de synchronisation entre les branches de l'arbre d'horloge. Le circuit DCT reçoit par exemple un signal CK1 prélevé à l'entrée de l'unité centrale UC, un signal CK2 prélevé à l'entrée du plan mémoire MA, et un signal CK3 prélevé à l'entrée du circuit CRYCT. Ces signaux d'horloge ou d'autres signaux d'horloge peuvent aussi être prélevés à l'intérieur de ces éléments si ceux-ci comportent des ramifications de l'arbre d'horloge. Le circuit DCT fournit le signal d'erreur synchrone SERS qui est envoyé à l'unité centrale pour prendre des mesures d'urgence en réponse au passage du signal SERS à la valeur active. Ces mesures d'urgence peuvent être exécutées par un circuit de protection à logique câblée spécifiquement prévu à cet effet, qui peut par exemple provoquer une remise à zéro hardware de l'unité centrale, un effacement, une destruction ou un verrouillage de certaines parties du plan mémoire, etc. Elles peuvent également être traitées par l'unité centrale en faisant basculer celle-ci dans un sous-programme dédié. Dans ce cas, et comme représenté, le signal d'erreur SERS est appliqué à un décodeur d'interruption ITDEC qui fournit à l'unité centrale UC un vecteur d'interruption ITV lorsque le signal d'erreur SERS présente la valeur active.

La présente invention est également susceptible de diverses applications autres que la surveillance d'un signal d'horloge. Par exemple, lorsque des données sont envoyées à plusieurs éléments à travers un arbre de données, un dispositif de détection selon l'invention peut être utilisé pour détecter une corruption de données dans l'arbre de données, par exemple la suppression ou l'ajout d'une donnée dans une branche de l'arbre.

## Revendications

1. Procédé de détection d'erreurs de synchronisation entre des signaux logiques (CK1-CK4) d'un groupe de signaux logiques, comprenant les étapes consistant à :
- prévoir un registre à décalage (SREG2) comprenant une première cellule synchrone (FFO) et une seconde cellule synchrone (FFA),
- charger un mot de contrôle (CW) dans le registre à décalage,
**caractérisé en ce qu'**il comprend les étapes consistant à :
- cadencer la première cellule synchrone (FFO) au moyen d'un premier signal logique résultant (CKO) égal au résultat de la fonction OU logique appliquée aux signaux logiques du groupe de signaux logiques (CK1-CK4),
- cadencer la seconde cellule synchrone (FFA) au moyen d'un second signal logique résultant (CKA) égal au résultat de la fonction ET logique appliquée aux signaux logiques du groupe de signaux logiques (CK1-CK4),
- propager le mot de contrôle en boucle dans le registre à décalage au rythme des signaux logiques résultants et surveiller la valeur du mot de contrôle au fur et à mesure de sa propagation, et
- détecter une erreur de synchronisation (ERS, SERS) si le mot de contrôle change de valeur.

2. Procédé selon la revendication 1, comprenant les étapes consistant à :
- produire un signal d'erreur asynchrone (ERS) ayant une valeur inactive et une valeur active, et porter le signal d'erreur asynchrone à la valeur active quand le mot de contrôle change de valeur,
- échantillonner le signal d'erreur asynchrone après chaque décalage du mot de contrôle dans le registre à décalage, afin de filtrer des erreurs de synchronisation tolérées et de produire un signal d'erreur synchrone (SERS).

3. Procédé selon la revendication 2, dans lequel le signal d'erreur synchrone (SERS) est rafraichi cycliquement par des fronts du premier signal logique résultant (CKO).

4. Procédé selon l'une des revendications 1 à 3, comprenant les étapes consistant à :
- charger dans le registre à décalage un mot de contrôle comprenant au moins un couple de bits de contrôle (bl, b2) ayant des valeurs logiques inverses, et
- détecter une erreur de synchronisation (ERS, SERS) si les bits de contrôle présentent la même valeur au cours de la propagation du mot de contrôle dans le registre à décalage.

5. Procédé selon l'une des revendications 1 à 4, comprenant une étape consistant à introduire entre la première cellule synchrone (FFO) et la seconde cellule synchrone (FFA) un retard de propagation (DLY) au moins égal à un décalage temporel maximal (SKW) toléré entre les signaux logiques.

6. Procédé selon l'une des revendications 1 à 5, dans lequel l'étape de chargement du mot de contrôle (CW) comprend une étape consistant à initialiser chaque cellule synchrone du registre à décalage avec un signal (INIT) de mise à 0 ou de mise à 1 de la cellule.

7. Procédé selon l'une des revendications 1 à 7, dans lequel les cellules synchrones du registre à décalage sont des bascules comprenant chacune une entrée d'horloge (CK) recevant l'un des signaux logiques résultants, une entrée de données (D) et une sortie de données inverseuse (/Q) ou non inverseuse (Q).

8. Procédé selon l'une des revendications 1 à 7, dans lequel les signaux logiques (CK1-CK4) dont la synchronisation doit être surveillée sont des signaux d'horloge prélevés en divers points d'un arbre d'horloge et issus d'un même signal d'horloge (CKr).

9. Dispositif (DCT2) de détection d'erreurs de synchronisation entre des signaux logiques (CK1-CK4) d'un groupe de signaux logiques, comprenant :
- un registre à décalage (SREG2) comprenant une première cellule synchrone (FFO) et une seconde cellule synchrone (FFA),
- des moyens (INIT, SET, RST) pour charger un mot de contrôle (CW) dans le registre à décalage,
**caractérisé en ce qu'**il comprend :
- des moyens pour connecter la sortie du registre à décalage à l'entrée du registre à décalage,
- des moyens (OG2) pour cadencer la première cellule synchrone (FFO) au moyen d'un signal logique résultant (CKO) égal au résultat de la fonction OU logique appliquée aux signaux logiques du groupe de signaux logiques (CK1-CK4), et
- des moyens (AG2) pour cadencer la seconde cellule synchrone (FFA) au moyen d'un signal logique résultant (CKA) égal au résultat de la fonction ET logique appliquée aux signaux logiques du groupe de signaux logiques (CK1-CK4), et
- des moyens (WCT2, IV1, FF5) pour surveiller la valeur du mot de contrôle au fur et à mesure de sa propagation en boucle dans le registre à décalage au rythme des signaux logiques, et émettre un signal d'erreur de synchronisation (ERS, SERS) si le mot de contrôle change de valeur.

10. Dispositif selon la revendication 9, dans lequel les moyens (WCT2) pour surveiller la valeur du mot de contrôle comprennent :
- des moyens (XOR5) pour produire un signal d'erreur asynchrone (ERS) ayant une valeur inactive et une valeur active, et porter le signal d'erreur asynchrone à la valeur active quand le mot de contrôle change de valeur, et
- des moyens (FF5) pour échantillonner le signal d'erreur asynchrone après chaque décalage du mot de contrôle dans le registre à décalage, afin de filtrer des erreurs de synchronisation tolérées et produire un signal d'erreur synchrone (SERS).

11. Dispositif selon la revendication 10, dans lequel les moyens (FF5) pour échantillonner le signal d'erreur asynchrone (ERS) sont pilotés par des fronts du premier signal logique résultant (CKO).

12. Dispositif selon l'une des revendications 9 à 11, dans lequel
- les moyens pour charger un mot de contrôle (CW) sont agencés pour charger dans le registre à décalage un mot de contrôle comprenant un couple de bits de contrôle (b1-b2) ayant des valeurs logiques inverses, et
- les moyens (WCT2) pour surveiller la valeur du mot de contrôle sont agencés pour émettre le signal d'erreur (ERS, SERS) si les bits de contrôle présentent la même valeur au cours de la propagation du mot de contrôle dans le registre à décalage.

13. Dispositif selon la revendication 9 à 12, dans lequel le registre à décalage (SREG2) comprend, entre la première cellule synchrone (FFO) et la seconde cellule synchrone (FFA), un circuit à retard (DLG) introduisant un retard de propagation (DLY) au moins égal à un décalage temporel maximal (SKW) toléré entre les signaux logiques.

14. Dispositif selon l'une des revendications 9 à 13, dans lequel les moyens pour charger un mot de contrôle (CW) dans le registre à décalage comprennent un signal (INIT) de mise à 0 ou de mise à 1 de chaque cellule synchrone du registre à décalage.

15. Dispositif selon l'une des revendications 9 à 14, dans lequel les cellules synchrones du registre à décalage sont des bascules (FF) comprenant chacune une entrée d'horloge (CK) recevant l'un des signaux logiques résultants, une entrée de données (D) et une sortie de données inverseuse (/Q) ou non inverseuse (Q).

16. Dispositif selon l'une des revendications 9 à 15, comprenant des entrées connectées en divers points d'un arbre d'horloge recevant les signaux logiques (CK1-CK4) dont la synchronisation doit être surveillée, les signaux logiques dont la synchronisation doit être surveillée étant des signaux d'horloge issus d'un même signal d'horloge (CKr).

17. Circuit synchrone (SCT) comprenant des modules synchrones (SM1-SM4) cadencés par des signaux logiques (CK1-CK4) véhiculés par un arbre d'horloge, **caractérisé en ce qu'**il comprend un dispositif (DCT2) de détection d'erreurs de synchronisation selon l'une des revendications 9 à 16, recevant des signaux logiques (CK1-CK4) appliqués aux modules synchrones (SM1-SM4).

18. Circuit intégré (IC) comprenant des organes synchrones (UC, MA CRYCT) cadencés par des signaux logiques (CK1-CK3) véhiculés par un bus d'horloge (CKB), **caractérisé en ce qu'**il comprend un dispositif (DCT2) de détection d'erreurs de synchronisation selon l'une des revendications 9 à 16, recevant des signaux logiques appliqués aux organes synchrones (UC, MA, CRYCT) ou prélevés à l'intérieur des organes synchrones.
